# EUROPÄISCHE PATENTSCHRIFT

(11) **EP 0 714 129 B1**
(45) Veröffentlichungstag und Bekanntmachung des Hinweises auf die Patenterteilung: **19.07.2000**
(21) Anmeldenummer: 95118214.6
(22) Anmeldetag: 17.11.1995
(51) Int. Cl.: H01L 23/522

(54) **Halbleiterbauelement**
Semiconductor device
Dispositif semi-conducteur

(30) Priorität: 24.11.1994 DE 4441898
(43) Veröffentlichungstag der Anmeldung: 29.05.1996
(73) Patentinhaber: SIEMENS AKTIENGESELLSCHAFT, 80333 München (DE)
(72) Erfinder: Kerber, Martin, Dr., D-81827 München (DE); Klose, Helmut, Dr., D-81929 München (DE); vom Felde, Andreas, Dr., Wappingers Fall, N.Y. 12590 (US)

(56) Entgegenhaltungen:
- EP-A- 0 373 360
- EP-A- 0 393 635
- US-A- 5 310 700

## Beschreibung

Die Kapazität von Leiterbahnen ist einer der limitierenden Faktoren für die Schaltgeschwindigkeit von integrierten Schaltungen auf Halbleiterchips. Mit kleineren lateralen Dimensionen werden auch die Abstände zwischen den verschiedenen Leiterbahnen kleiner, so daß in gleichem Maße die Koppelkapazitäten zwischen benachbarten Leiterbahnen ansteigen. Bei höherer Integrationsdichte spielen auch die Kapazitäten zwischen verschiedenen Metallisierungsebenen eine Rolle. Darüber hinaus nimmt, insbesondere in Logikschaltkreisen mit zunehmender Integrationsdichte, die mittlere von einem Gatter zu treibende Leiterbahnlänge zu, so daß entweder leistungsfähigere Treiberstufen und/oder eine Reduktion der Versorgungsspannung notwendig sind. Üblicherweise wird bei integrierten Schaltkreisen auf Siliziumscheiben Oxid als Intermetalldielektrikum (IMOX) eingesetzt, das durch Niedertemperatur-CVD (Chemical Vapor Deposition) aufgebracht wird.

In der GB-PS 22 47 986, der EP 603 104 A1, der EP 501 407 A1 und der EP 393 635 sind Halbleiterbauelemente beschrieben, bei denen zwischen Leiterbahnen oder Metallisierungen Zwischenräume, die mit Luft oder einem Gas gefüllt sind, vorhanden sind, die die zwischen den Leiterbahnen auftretenden Kapazitäten verringern. Diese Zwischenräume sind als Gräben, Hohlräume oder wabenartige Zellen gestaltet.

In der EP 0 373 360 A2 ist ein Verfahren zur Herstellung der Leiterbahnisolationen auf VLSI-ICs und ULSI-ICs beschrieben. Bei diesem Verfahren wird zwischen metallischen Leiterbahnen, die auf einem SiO₂-Träger aufgebracht sind, ein organisches Polymer aufgebracht und planarisiert. Die Oberseite wird mit einer SiO₂-Schicht versehen, in der mittels Photolack Ätzlöcher hergestellt werden. Durch die Ätzlöcher hindurch wird das Polymer zwischen den Leiterbahnen entfernt. Eine Alternative zu diesem Verfahren beschreibt die Herstellung stegförmiger Strukturen auf den Leiterbahnen, die in das organische Polymer vergraben werden. Eine Deckschicht aus SiO₂ wird aufgebracht und mittels Photolack als Maske mit Ätzlöchern versehen. Durch diese Ätzlöcher wird das Polymer unter der SiO₂-Schicht zwischen den Leiterbahnen entfernt. Mit den geätzten Hohlräumen soll die Kapazität zwischen den Leiterbahnen vermindert werden.

Aufgabe der vorliegenden Erfindung ist es, ein vereinfachtes Verfahren zur Herstellung eines Halbleiterbauelementes mit Metallisierungen, Kontakten oder Leiterbahnen anzugeben, bei dem zur Verminderung der zwischen diesen Leitern auftretenden Kapazitäten mit Luft oder einem Gas gefüllte Zwischenräume vorgesehen sind.

Diese Aufgabe wird mit dem Verfahren mit den Merkmalen des Anspruches 1 gelöst. Weitere Ausgestaltungen ergeben sich aus den abhängigen Ansprüchen.

Bekanntermaßen ist die Kapazität proportional zur Dielektrizitätskonstante des Materials zwischen den Elektroden, so daß eine geringere Kapazität zwischen Leiterbahnen erreicht wird, wenn der Zwischenraum zwischen den Leiterbahnen mit einem Material mit möglichst kleiner Dielektrizitätskonstante ausgefüllt ist. Bei dem erfindungsgemäße hergestellten Bauelement befinden sich zwischen den Leiterbahnen bereichsweise Hohlräume, in denen das Intermetalldielektrikum durch Luft oder ein Immersionsgas ersetzt ist. Im Bereich der Hohlräume ist daher die Kapazität wesentlich reduziert. Ausreichende elektrische Isolation ist auch bei Langzeitbelastung gewährleistet. Die Leiterbahnen behalten eine ausreichende mechanische Stabilität durch das die Hohlräume voneinander trennende restliche Dielektrikum, das in dem Bereich der Metallisierungsschichten in voller Höhe vorhanden ist, d. h. alle übereinander vorhandenen Metallisierungen einschließt oder trägt. Die erfindungsgemäße Herstellung des Bauelementes ist einfach und im Rahmen des üblichen Herstellungsprozesses durchführbar, weil Luft oder das spezielle Immersionsgas mit der Halbleitertechnologie kompatibel sind.

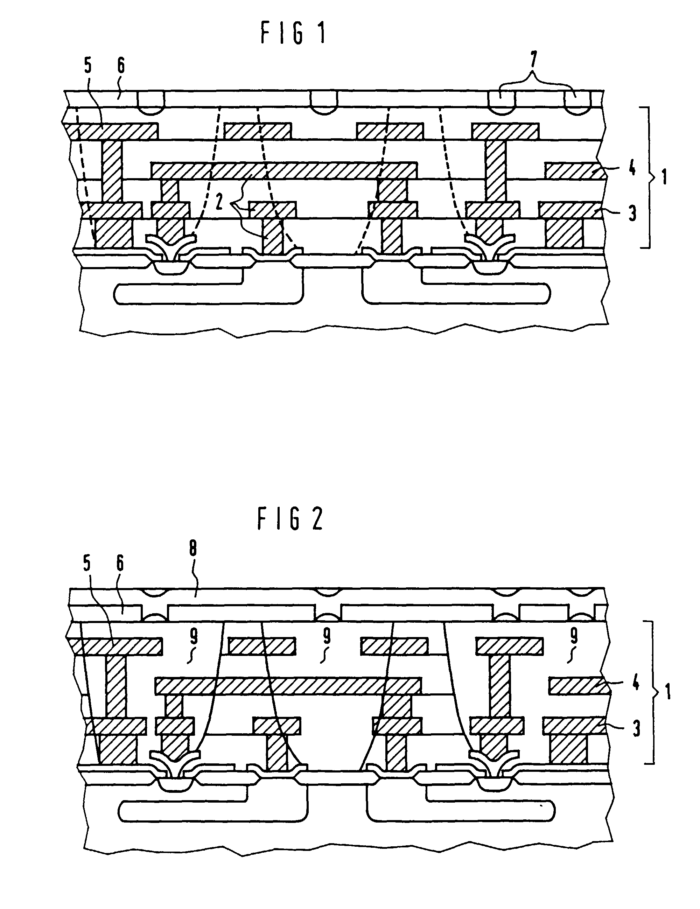

Das erfindungsgemäße Verfahren wird im folgenden anhand der Figuren 1 und 2 die das Bauelement nach verschiedenen Schritten des Verfahrens im Querschnitt zeigen, dargestellt.

In Figur 1 ist eine Vielzahl von schraffiert eingezeichneten Kontakten, Metallisierungen und Leiterbahnen 2, die durch Dielektrikum voneinander isoliert sind, in einem Bereich 1 auf der Oberseite eines Bauelementes dargestellt. In dem bezeichneten Beispiel befinden sich zwei Bipolartransistoren auf der Oberseite eines Substrates, die miteinander und mit weiteren Bauelementen verschaltet sind. In dem beschriebenen Ausführungsbeispiel befinden sich daher diverse Kontakte auf verschiedenen Bereichen des Halbleitermateriales. Auf den Kontakten ist eine strukturierte erste Metallisierungsebene 3 aufgebracht. Darüber befinden sich weitere Metallisierungsebenen 4, 5, die jeweils vertikale Verbindungen aus Metall aufweisen. Die Leiterbahnen und leitenden Verbindungen in dieser Struktur aus Metall sind voneinander durch Dielektrikum, in das die Metallisierungen eingebettet sind, elektrisch isoliert. Auf der Oberseite des mit dem Dielektrikum vorzugsweise planarisierten Bereiches 1 ist eine Passivierungsschicht 6 aufgebracht, die z. B. bei einem Bauelement auf Silizium vorzugsweise durch Siliziumnitrid gebildet sein kann. Zur Reduktion der Leiterbahnkapazität wird dann das Dielektrikum in dem Bereich 1 durch eine räumlich begrenzte isotrope Ätzung bereichsweise entfernt, wobei die Zwischenräume zwischen den Leiterbahnen mit Luft oder Immersionsgas gefüllt werden. Zu diesem Zweck werden in die Passivierungsschicht 6 Öffnungen 7 geätzt, die in Zahl und Größe so gestaltet sind, daß anschließend die Ätzung des darunter vorhandenen Dielektrikums erfolgen kann und sich die Öffnungen anschließend mit einer weiteren Passivierung verschließen lassen, ohne daß die ausgeätzten Hohlräume wieder aufgefüllt werden. Die Öffnungen 7 sind bevorzugt im Bereich der Metallisierungen angeordnet. Es kann von Vorteil sein, wie im Fall der mittleren Öffnung in Figur 1, diese Öffnung über einem Bereich anzuordnen, in dem es besonders wichtig ist, die Kapazitäten zwischen den Leiterbahnen zu reduzieren, auch wenn dort keine Bauelemente integriert sind. Die Ätzung der Hohlräume unter den Öffnungen 7 erfolgt isotrop selektiv zu den Leiterbahnen und zu der Passivierungsschicht 6. Das Material dieser Passivierungsschicht 6 ist entsprechend auszuwählen, so daß bei der Ätzung des Dielektrikums das Material der Passivierungsschicht möglichst nicht angegriffen wird. Die Ätzung kann z. B. mittels HF-Gas oder Zusatz von HNO₃ erfolgen, wenn z. B. SiO₂ für den Bereich 1 und Nitrid für die Passivierungsschicht 6 verwendet wird. Um die selektive Ätzbarkeit des Dielektrikums zu den Leiterbahnen zu verbessern, kann es vorteilhaft sein, wenn die Leiterbahnen aus Wolfram hergestellt werden.

Zwischen den Leiterbahnen und Kontakten werden auf diese Weise in den in Figur 1 gestrichelt umrandeten Bereichen Hohlräume hergestellt. Durch eine zeitliche Begrenzung des Ätzangriffes wird sichergestellt, daß die räumlichen Abmessungen dieser Hohlräume nicht zu groß werden, so daß zwischen den Hohlräumen ausreichend große Bereiche bleiben, in denen das Dielektrikum zur mechanischen Stabilisierung der Leiterbahnen stehenbleibt. Nach dieser Ätzung der Hohlräume wird das Bauelement mit einer weiteren Passivierungsschicht 8 wie in Figur 2 gezeigt abgedeckt, wodurch die Öffnungen 7 in der ersten Passivierungsschicht 6 ohne nennenswerte Abscheidung im Inneren der Hohlräume verschlossen werden. Diese Abscheidung erfolgt vorzugsweise diffusionskontrolliert und in einem Trägergas, das als späteres Immersionsgas die verschlossenen Hohlräume füllt. Der Herstellungsprozeß für integrierte Schaltungen kann dann mit der Öffnung von Anschlußflächen für den externen elektrischen Anschluß (Bonddrähte) fortgesetzt werden.

Figur 2 zeigt typische Ausgestaltungen des erfindungsgemäßen Bauelementes als Beispiele. Die Hohlräume 9 reichen hier bis auf das Halbleitermaterial hinunter, umfassen also die gesamte Dicke des für die Metallisierungen vorgesehenen Bereiches 1. Damit beim Ätzen der Hohlräume das Halbleitermaterial nicht angegriffen und beschädigt wird, kann es von Vorteil sein, wenn die Hohlräume nicht bis auf das Halbleitermaterial hinab ausgeätzt werden. Ausreichend große Hohlräume erreicht man z. B. durch eine entsprechend dichte Anordnung der für das Ätzen vorgesehenen Öffnungen 7. Als zusätzliche Sicherheit kann vor dem Aufbringen der Metallisierungen eine weitere Passivierungsschicht unmittelbar auf dem Halbleitermaterial aufgebracht werden. Diese Passivierungsschicht kann z. B. aus demselben Material sein wie die Passivierungsschichten 6, 8 auf der Oberseite des Bereiches 1 der in Dielektrikum eingebetteten Metallisierungen. Beim selektiven Ätzen des Dielektrikums wird diese Passivierungsschicht nicht angegriffen, so daß das Halbleitermaterial geschützt bleibt. Die laterale Ausdehnung der Hohlräume und damit die maximale Länge der freigelegten Anteile der Leiterbahnen muß so bemessen sein, daß die Metallbahnen im Betrieb ausreichend mechanisch stabilisiert sind, daß schichtinterne mechanische Spannungen aufgenommen werden und daß beim Freiätzen die Metallbohnen nicht zusammenhaften (Sticking).

Die erfindungsgemäße Ausgestaltung des Bauelementes ist von der Art der realisierten aktiven Komponenten und der Struktur der Kontakte und Leiterbahnen unabhängig, so daß die beschriebene Maßnahme zur Reduktion der Kapazitäten zwischen den Leiterbahnen bei Halbleiterbauelementen universell eingesetzt werden kann. Daraus ergibt sich eine wesentliche Verbesserung der Funktionsweise der Bauelemente bei sehr geringem zusätzlichem Herstellungsaufwand. Die Anwendung ist außerdem nicht auf Leiterbahnen und Kontakte aus Metall beschränkt, die erfindungsgemäße Reduktion der Kapazitäten kann auch bei Leiterbahnen aus elektrisch leitend dotiertem Halbleitermaterial, z. B. Polysilizium, angewendet werden. Bei dem erfindungsgemäßen Bauelement können Leiterbahnen in nur einer Metallisierungsebene oder in verschiedenen Metallisierungsebenen vorhanden sein. In einem Hohlraum können sich Leiterbahnen, die zu verschiedenen Metallisierungsebenen gehören, befinden. Es können sich in einem Hohlraum statt dessen nur Anteile von Leiterbahnen derselben Metallisierungsebene befinden.

## Patentansprüche

1. Verfahren zur Herstellung eines Halbleiterbauelementes mit elektrisch leitenden Kontakten und/oder Leiterbahnen (2), die bereichsweise durch Dielektrikum voneinander getrennt und bereichsweise von mit Gas gefüllten und nach außen abgeschlossenen Hohlräumen (9) umgeben sind,
mit folgenden Schritten:
a) Das Halbleiterbauelement wird soweit fertiggestellt, daß durch Dielektrikum elektrisch voneinander isolierte Kontakte und/oder Leiterbahnen (2) aufgebracht sind;
b) die mit diesen Kontakten und/oder Leiterbahnen versehene Seite des Bauelementes wird mit einer Passivierungsschicht (6), bezüglich der sich das Dielektrikum selektiv entfernen läßt, bedeckt;
c) in dieser Passivierungsschicht werden Öffnungen (7) hergestellt, die für den nachfolgenden Schritt d) groß und zahlreich genug und für den nachfolgenden Schritt e) klein genug sind;
d) durch diese Öffnungen hindurch wird bereichsweise das Dielektrikum um die Kontakte und/oder Leiterbahnen herum selektiv zu den Kontakten und/oder Leiterbahnen und zu der Passivierungsschicht (6) weggeätzt, um die Hohlräume (9) herzustellen;
e) durch eine zeitliche Begrenzung des Ätzangriffes werden die räumlichen Abmessungen dieser Hohlräume so begrenzt, daß zwischen den Hohlräumen das Dielektrikum zur mechanischen Stabilisierung der Kontakte und/oder Leiterbahnen stehenbleibt;
f) die Öffnungen (7) werden durch Abscheiden einer weiteren Passivierungsschicht (8) verschlossen, ohne daß die Hohlräume aufgefüllt werden.

2. Verfahren nach Anspruch 1,
bei dem Schritt f) in einem Trägergas erfolgt, das als Immersionsgas für die Hohlräume vorgesehen ist.

3. Verfahren nach Anspruch 1 oder 2,
bei dem in Schritt d) die Größe der ausgeätzten Hohlräume so begrenzt wird, daß die maximale Länge der in den Hohlräumen freigelegten Leiterbahnen ausreichend klein ist, um ein Haften (Sticking) zu vermeiden.

4. Verfahren nach einem der Ansprüche 1 bis 3,
bei dem in den Schritten b) und f) Nitrid als Material der Passivierungsschicht abgeschieden wird.

## Claims

1. Method for fabricating a semiconductor device with electrically conductive contacts and/or interconnects (2), which are isolated from one another by dielectric in regions and are surrounded in regions by gas-filled cavities (9) closed off to the outside, having the following steps:
a) the semiconductor device is completed to the extent that contacts and/or interconnects (2) electrically insulated from one another by dielectric are applied;
b) that side of the device which is provided with these contacts and/or interconnects is covered with a passivation layer (6), with respect to which the dielectric can be selectively removed;
c) openings (7) are made in this passivation layer, which openings are large and numerous enough for the subsequent step d) and small enough for the subsequent step e);
d) through these openings, the dielectric around the contacts and/or interconnects is etched away in regions selectively with respect to the contacts and/or interconnects and with respect to the passivation layer (6), in order to produce the cavities (9);
e) by limiting the time duration of the etching attack, the spatial dimensions of these cavities are limited in such a way that the dielectric remains between the cavities for the purpose of mechanically stabilizing the contacts and/or interconnects;
f) the openings (7) are closed off by the deposition of a further passivation layer (8), without the cavities being filled in.

2. Method according to Claim 1,
in which step f) is carried out in a carrier gas provided as immersion gas for the cavities.

3. Method according to Claim 1 or 2,
in which, in step d), the size of the etched-out cavities is limited in such a way that the maximum length of the interconnects uncovered in the cavities is small enough to avoid sticking.

4. Method according to one of Claims 1 to 3,
in which, in steps b) and f), nitride is deposited as the material of the passivation layer.

## Revendications

1. Procédé de fabrication d'un élément semi-conducteur pourvu de contacts électroconducteurs et/ou de pistes conductives (2) qui sont séparés les uns des autres par endroits par un diélectrique et entourés par endroits par des cavités (9) fermées vers l'extérieur et remplies de gaz, comprenant les étapes suivantes :
a) l'élément semi-conducteur est préparé jusqu'au moment où des contacts et/ou pistes conductives (2) isolés électriquement les uns des autres par un diélectrique sont appliqués ;
b) le côté de l'élément pourvu de ces contacts et/ou pistes conductives est couvert d'une couche de passivation (6) par rapport à laquelle le diélectrique peut être éliminé de manière sélective ;
c) on fabrique dans cette couche de passivation des ouvertures (7) qui sont suffisamment grandes et nombreuses pour l'étape d) suivante et suffisamment petites pour l'étape e) suivante ;
d) à travers ces ouvertures, le diélectrique est éliminé par gravure, par endroits, autour des contacts et/ou pistes conductives, de manière sélective par rapport aux contacts et/ou pistes conductives et à la couche de passivation (6) afin de fabriquer les cavités (9) ;
e) en limitant dans le temps l'attaque chimique, on limite les dimensions spatiales de ces cavités de manière à ce que le diélectrique subsiste entre les cavités en vue de la stabilisation mécanique des contacts et/ou pistes conductives ;
f) les ouvertures (7) sont fermées par dépôt d'une nouvelle couche de passivation (8) sans que les cavités soient remplies.

2. Procédé selon la revendication 1, dans lequel l'étape f) se déroule dans un gaz porteur qui est prévu en tant que gaz d'immersion pour les cavités.

3. Procédé selon l'une des revendications 1 ou 2, dans lequel, dans l'étape d), la grandeur des cavités creusées par gravure est limitée de manière à ce que la longueur maximale des pistes conductives dégagées dans les cavités soit suffisamment petite pour éviter un collage (sticking).

4. Procédé selon l'une des revendications 1 à 3, dans lequel, dans les étapes b) et f), on dépose du nitrure en tant que matériau de la couche de passivation.
